# EUROPEAN PATENT SPECIFICATION

(11) **EP 4 105 694 B1**
(45) Date of publication and mention of the grant of the patent: **31.12.2025**
(21) Application number: 21753084.9
(22) Date of filing: 04.02.2021
(51) Int. Cl.: G02B 5/02, H05B 33/02, H05B 33/04, H05B 33/10, G02B 1/118, G02B 27/01, G09F 9/30

(54) **DISPLAY DEVICE, ELECTRONIC APPARATUS, AND METHOD FOR PRODUCING DISPLAY DEVICE**
ANZEIGEVORRICHTUNG, ELEKTRONISCHES GERÄT UND VERFAHREN ZUR HERSTELLUNG EINER ANZEIGEVORRICHTUNG
DISPOSITIF D'AFFICHAGE, APPAREIL ÉLECTRONIQUE ET PROCÉDÉ DE PRODUCTION DE DISPOSITIF D'AFFICHAGE

(30) Priority: 13.02.2020 JP 2020022417
(43) Date of publication of application: 21.12.2022
(73) Proprietor: Sony Semiconductor Solutions Corporation, Atsugi-shi Kanagawa 243-0014 (JP)
(72) Inventor: NAKATA, Masashi, Atsugi-shi, Kanagawa 243-0014 (JP); JINTA, Seiichiro, Atsugi-shi, Kanagawa 243-0014 (JP)
(74) Representative: Müller Hoffmann & Partner
(86) International application number: PCT/JP2021/004047
(87) International publication number: WO 2021/161882

(56) References cited:
- EP-A1- 3 392 682
- EP-A1- 3 609 165
- WO-A1-2018/196149
- CN-A- 110 071 121
- CN-A- 110 534 541
- CN-A- 110 783 347
- CN-A- 110 783 347
- US-A1- 2016 282 663
- US-A1- 2017 345 152
- US-A1- 2020 126 472

## Description

### TECHNICAL FIELD

The present disclosure relates to a display device, an electronic apparatus, and a method for manufacturing the display device.

### BACKGROUND ART

In a recent electronic apparatus such as a smartphone, a mobile phone, or a personal computer (PC), the frame (bezel) of its display panel is equipped with various sensors such as a camera. However, there is a demand for making the outer size of such an electronic apparatus as compact as possible without affecting the screen size, and the bezel width tends to be narrowed. In view of such a background, a technique has been proposed in which a camera module is disposed immediately below the display panel and subject light passed through the display panel is shot by the camera module.

US 2021/359024 A1 discloses a display panel includ an array substrate, an organic light-emitting layer, a thin-film encapsulation layer, and a polarizing film. The array substrate includes at least two inorganic layers disposed on an underlay substrate. In a transparent display region, at least two inorganic layers include at least one first hole. The organic light-emitting layer has faults in a position of the first hole. A transparent sealant is used to cover edges of the faults of the organic light-emitting layer. CN 110 783 347 A discloses a display panel and a preparation method thereof, wherein a yellow polyimide material in a camera area is removed to form a camera hole, a transparent polyimide material is filled in the camera hole, the excellent heat resistance and mechanical property of the yellow polyimide material and the high light transmittance of the transparent polyimide material are utilized, so that the prepared display panel has good heat resistance and mechanical property, can improve the transmittance at the camera hole, meets the requirement of camera shooting under a screen, is convenient to improve the screen ratio, and brings better impression experience to users.

CN 110 534 541 A discloses an electroluminescent display panel and a display device, wherein the display region comprises a photosensitive device arranging region, a camera or fingerprint recognition device is arranged in the photosensitive device arranging region, rather than in the frame, and thus a relatively larger area occupying in the frame is avoided, to allow the frame be made narrower, and the screen-to-body ratio be increased. Also for the photosensitive device arranging region, the first signal lines and the second signal lines are arranged more intensively by arranging a plurality of overlap areas in the orthographic projection of one first pixel on the base substrate, to allow the display panel have more concentrated space as the light-transmission region, so that the light transmittance of the photosensitive device arranging region can be increased to provide more lights to the camera or fingerprint recognition device. EP 3 609 165 A1 discloses an LCD display including several transparent material layers and several non-transparent material layers that are disposed in stack mode. There is a local transparent region on the LCD display. No non-transparent material is applied to the several non-transparent material layers in the local transparent region, to form a transparent channel in the local transparent region along a stacking direction. An optical component is completely or partially disposed in the transparent channel of the LCD display.

US 2017/345152 A1 discloses a display device including a display panel includes a substrate divided into a light-emitting region and a non-light-emitting region including a sensing area, a pixel disposed on the light-emitting region, and a pixel-defining layer disposed on the non-light-emitting region, and a sensing panel which is disposed on the display panel and includes a sensing transistor configured to sense light that is emitted from the pixel and reflected by an external object. The sensing transistor overlaps the sensing area in a first direction parallel to a thickness direction of the display panel, is spaced apart from the light-emitting region in a second direction perpendicular to the first direction, and generates a current by receiving the light. The generated current may be used to sense light which is emitted from the pixel and reflected by an external object, such as a fingerprint, to allow the display to act as a biometric sensor.

EP3392682A1 discloses a method of forming an antireflection optical body including: an application step of applying a photocurable resin onto one surface side of an adherend; a pressing step of pressing a substrate film having a fine structure body at one surface side against the photocurable resin from an opposite surface side by a light guide; a curing step of curing the photocurable resin by transmitting light through the light guide; and a peeling separation step of releasing the pressing of the substrate film and peeling fixed fine structure body that is fixed to the adherend through the cured photocurable resin substrate film while separating the fixed fine structure body from fine structure body on the substrate film other than at a location fixed through the photocurable resin such that the fixed fine structure body is formed on the adherend as an antireflection optical body.

### CITATION LIST

### PATENT DOCUMENT

Patent Document 1: US Patent Publication No. 2018/0069060

### SUMMARY OF THE INVENTION

### PROBLEMS TO BE SOLVED BY THE INVENTION

A sealing material for preventing moisture or the like from intruding from the outside is required for a display panel, and polyimide is typically used for the sealing material. Polyimide is also excellent in heat resistance, and can withstand a heat treatment process in formation of a thin film transistor (TFT).

Polyimide, however, is low in transmittance to visible light. When shooting is performed with the camera module through the display panel as described above, the shooting image quality deteriorates.

Although development to make polyimide transparent has also been advanced, when polyimide is made transparent, heat resistance deteriorates typically. Thus, there is a possibility that the electrical characteristics of the TFT formed on the display panel are deteriorated.

Therefore, the present disclosure provides a display device, an electronic apparatus, and a method for manufacturing the display device that enable improvement in transmittance without impairing display quality.

### SOLUTIONS TO PROBLEMS

The problem is solved by the teachings of the independent claims. Further embodiments are defined in the dependent claims. The invention is defined by the appended claims. References to embodiments which do not fall under the scope of the claims are to be understood as examples useful for understanding the invention.

According to the present disclosure, provided is a display device including: a substrate;
a first display region disposed on the substrate, the first display region having a plurality of pixels; and
a second display region disposed on the substrate, the second display region having a plurality of pixels,
in which the substrate has a first transmittance in the first display region, and
the substrate has a second transmittance in the second display region higher than the first transmittance.

The second display region faces a sensing device disposed on a side of a face opposite to a display face on the substrate.

The display device further includes : a first film disposed on the side of the face opposite to the display face within the first display region, the first film having the first transmittance.

The display device may further include: a second film disposed on the side of the face opposite to the display face within the second display region, the second film having the second transmittance.

The second film may be disposed on the side of the face opposite to the display face in at least part of the second display region, the part including a boundary portion between adjacent pixels within the second display region.

A ratio of an area of the second film to an area of a light emitting region within the second display region may be 30% or more.

The second film may have a function of cutting infrared light.

The second film may be disposed at an opening formed by removal of part of the first film, and
a transmittance of a boundary portion between the first film and the second film may vary continuously or stepwise from the first film to the second film.

The first film may contain polyimide, and
the second film may contain a material higher in transmittance than the polyimide of the first film.

The second film may have at least one of a concave portion or a convex portion.

The display device may further include: an optical lens including the second film.

The display device may further include: a moth-eye structure layer including the second film.

The first film is provided in at least part of the second display region, the at least part excluding a boundary portion between adjacent pixels within the second display region, and
an opening of the first film is provided at the boundary portion between the adjacent pixels within the second display region.

The first transmittance to visible light having a wavelength of 400 nm may be 0 to 50%, and
the second transmittance to the visible light may be 51 to 100%.

According to the present disclosure, provided is an electronic apparatus including: a display device;
a sensing device disposed opposite a display face of the display device,
in which the display device includes:
   a substrate;
   a first display region disposed on the substrate, the first display region having a plurality of pixels; and
   a second display region disposed on the substrate, the second display region having a plurality of pixels,
   the substrate has a first transmittance in the first display region, and
   the substrate has a second transmittance in the second display region higher than the first transmittance.

The sensing device may include an imaging sensor.

The sensing device may include a biometric-information detection sensor.

A plurality of the second display regions may be provided on the display face, and
a plurality of the sensing devices may be disposed corresponding to the plurality of the second display regions.

The respective second transmittances of at least two of the plurality of the second display regions may be different from each other.

According to the present disclosure, provided is a method for manufacturing a display device, the method comprising:
forming a first film having a first transmittance on a first support substrate;
forming a light emitting layer on the first film;
forming a protective film on the light emitting layer;
forming a second support substrate on the protective film;
removing the first support substrate; and
forming an opening at the first film so as to be coincident with a disposition place of a sensing device.

The method may further include: forming a second film at the opening, the second film having a second transmittance higher than the first transmittance.

According to the present disclosure, provided is a manufacturing method, the method comprising:
forming a first film having a first transmittance on a support substrate;
forming an opening at the first film so as to be coincident with a disposition place of a sensing device;
filling the opening with an insulating member;
forming a first protective film on the first film;
forming a light emitting layer on the first protective film;
forming a second protective film on the light emitting layer; and
removing the insulating member to form the opening at the first film.

The method may further include: forming a second film at the opening formed by the removing, the second film being higher in transmittance than the first film.

### BRIEF DESCRIPTION OF DRAWINGS

**Fig.** 1 is a schematic external view of an electronic apparatus equipped with a display device according to a first embodiment.
**Fig.** 2A is a schematic sectional view illustrating part of a second display region.
**Fig.** 2B is a schematic sectional view illustrating part of a first display region.
**Fig.** 2C is a schematic sectional view of a display device including the first display region and the second display region.
**Fig.** 2D is a schematic sectional view of the display device with a first film and a second film disposed in the second display region.
**Fig.** 3A is a sectional view illustrating a manufacturing process of the display device according to the first embodiment.
**Fig.** 3B is a process sectional view following **Fig. 3A****.**
**Fig.** 3C is a process sectional view following **Fig. 3B****.**
**Fig.** 3D is a process sectional view following **Fig. 3C****.**
**Fig.** 3E is a process sectional view following **Fig. 3D****.**
**Fig.** 3F is a process sectional view following **Fig. 3E****.**
**Fig.** 4A illustrates an example in which the density of a region low in transmittance increases stepwise from the center to the peripheral edge of a transmissive member.
**Fig.** 4B illustrates an example in which the transmittance continuously varies from the center to the peripheral edge of the transmissive member.
Fig. 5A is a sectional view illustrating a process of forming a lens at a transmissive member.
Fig. 5B is a process sectional view following Fig. 5A.
Fig. 5C is a process sectional view following Fig. 5B.
Fig. 5D is a process sectional view following Fig. 5C.
Fig. 5E is a process sectional view following Fig. 5D.
Fig. 5F is a process sectional view following Fig. 5E.
Fig. 6A is an explanatory view schematically illustrating an exemplary procedure of an imprinting process.
Fig. 6B is a process sectional view following Fig. 6A.
Fig. 7A is a sectional view illustrating a manufacturing process of a display device according to a second embodiment.
Fig. 7B is a process sectional view following Fig. 7A.
Fig. 7C is a process sectional view following Fig. 7B.
Fig. 7D is a process sectional view following Fig. 7C.
Fig. 7E is a process sectional view following Fig. 7D.
Fig. 7F is a process sectional view following Fig. 7E.
Fig. 8A is a sectional view illustrating a manufacturing process of a display device according to a third embodiment.
Fig. 8B is a process sectional view following Fig. 8A.
Fig. 8C is a process sectional view following Fig. 8B.
Fig. 8D is a process sectional view following Fig. 8C.
Fig. 8E is a process sectional view following Fig. 8D.
Fig. 8F is a process sectional view following Fig. 8E.
Fig. 9A is a sectional view illustrating a manufacturing process of a display device according to a fourth embodiment.
Fig. 9B is a process sectional view following Fig. 9A.
Fig. 9C is a process sectional view following Fig. 9B.
Fig. 9D is a process sectional view following Fig. 9C.
Fig. 9E is a process sectional view following Fig. 9D.
Fig. 9F is a process sectional view following Fig. 9E.
Fig. 9G is a process sectional view following Fig. 9F.
Fig. 10A is a sectional view of a step performed instead of those in Figs. 9B and 9C.
Fig. 10B is a process sectional view following Fig. 10A.
Fig. 10C is a process sectional view following Fig. 10B.
Fig. 11A is a sectional view illustrating a manufacturing process of a display device according to a fifth embodiment.
Fig. 11B is a process sectional view following Fig. 11A.
Fig. 11C is a process sectional view following Fig. 11B.
Fig. 11D is a process sectional view following Fig. 11C.
Fig. 11E is a process sectional view following Fig. 11D.
Fig. 11F is a process sectional view following Fig. 11E.
Fig. 11G is a process sectional view following Fig. 11F.
Fig. 11H is a process sectional view following Fig. 11G.
Fig. 11I is a process sectional view following Fig. 11H.
Fig. 11J is a process sectional view following Fig. 11I.
Fig. 12 is a plan view of an electronic apparatus according to a sixth embodiment.
Fig. 13 illustrates a sectional structure of an imaging unit of a camera module with which an electronic apparatus is equipped according to a seventh embodiment.
Fig. 14 is a plan view of a capsule endoscope to which the electronic apparatus according to any of the first to seventh embodiments is applied.
Fig. 15 is a rear view of a digital single-lens reflex camera to which the electronic apparatus according to any of the first to seventh embodiments is applied.
Fig. 16A is a plan view illustrating an example in which the electronic apparatus 2 according to any of the first to seventh embodiments is applied to a head-mounted display (HMD).
Fig. 16B illustrates the current HMD.

### MODE FOR CARRYING OUT THE INVENTION

Hereinafter, embodiments of a display device will be described with reference to the drawings. Although main components of the display device will be mainly described below, such a display device 1 may have components and functions that are not illustrated or described. The following description does not exclude the components and functions that are not illustrated or described.

### (First Embodiment)

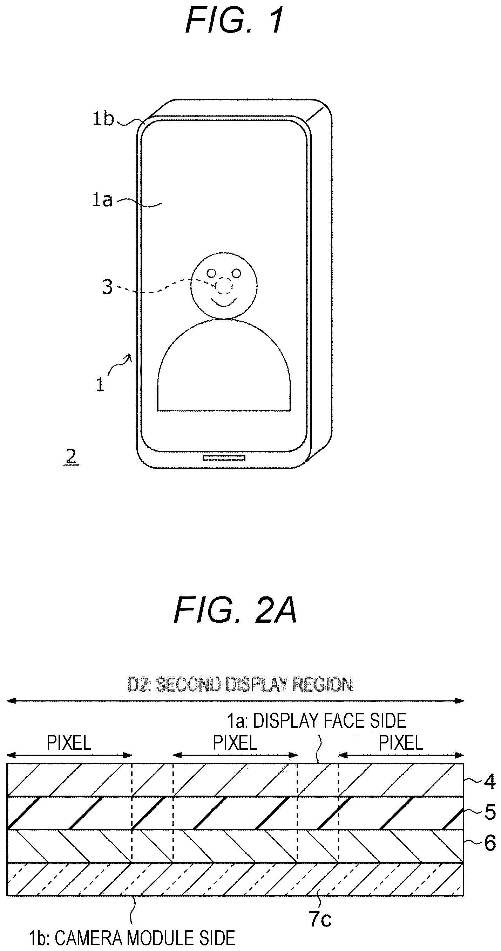

Fig. 1 is a schematic external view of an electronic apparatus 2 equipped with a display device 1 according to a first embodiment. The electronic apparatus 2 in Fig. 1 is any electronic apparatus 2 having both a display function and a shooting function, such as a smartphone, a mobile phone, a tablet, or a PC. The electronic apparatus 2 in Fig. 1 includes a camera module (imaging unit) 3 disposed opposite a display face 1a of the display device 1. In Fig. 1, the disposition place of the camera module 3 is indicated by a broken line. As described above, in the electronic apparatus 2 in Fig. 1A, the camera module 3 is provided on the rear side of the display face 1a of the display device 1. Therefore, the camera module 3 performs imaging through the display device 1. In the present specification, the display face 1a side of the display device 1 is referred to as a front face, and the side on which the camera module 3 is disposed is referred to as a rear face.

In the present embodiment, the transmittance of part of the display region overlapping the disposition place of the camera module 3 on the rear face side of the display device 1 is increased.

The display device 1 according to the present embodiment includes a first display region D1 and a second display region D2 disposed on a substrate. In the first display region D1, the substrate has a first transmittance. In the second display region D2, the substrate has a second transmittance higher than the first transmittance. The second display region D2 faces a a sensing device such as the camera module 3 disposed on the side of the face opposite to the display face on the substrate.

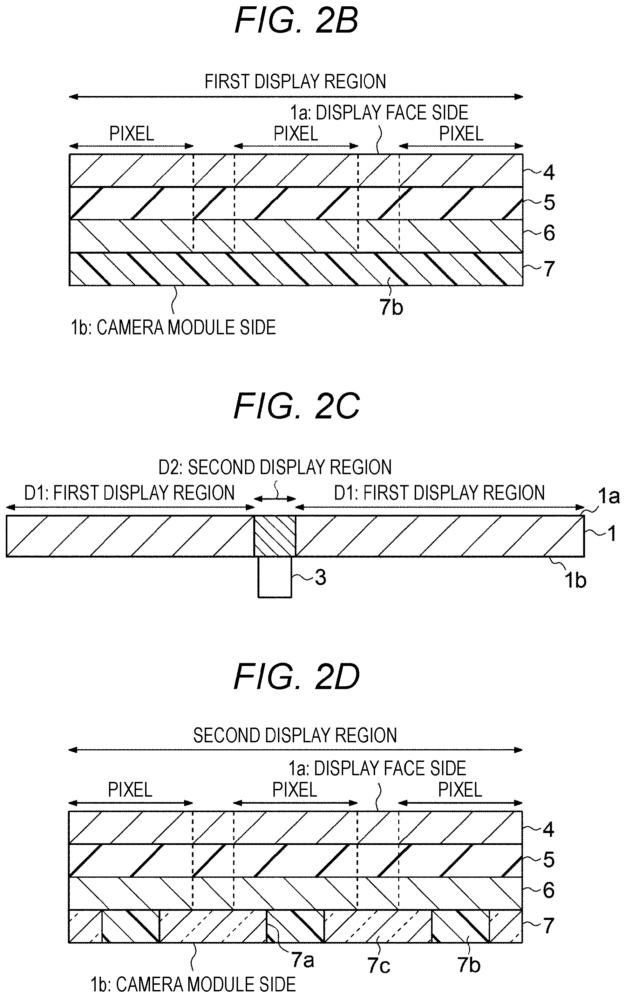

Fig. 2A is a schematic sectional view illustrating part of the second display region D2. Fig. 2B is a schematic sectional view illustrating part of the first display region D1. Fig. 2C is a schematic sectional view of the display device 1 including the first display region D1 and the second display region D2. Figs. 2A and 2B each illustrate the region including three adjacent pixels. Each pixel has an upper electrode 4, a light emitting layer 5, and a lower electrode 6. In practice, such a pixel has a complicated layered configuration, but is illustrated in a simplified manner in Figs. 2A and 2B. The upper face in Figs. 2A and 2B is the display face 1a, and the camera module 3 is disposed on the lower face side.

As illustrated in Fig. 2B, a base film 7 is disposed under the lower electrode 6 in the first display region D1. The base film 7 includes opaque polyimide low in transmittance. Due to the low transmittance of the base film 7, light from the display face 1a side is blocked by the base film 7, resulting in a decrease in the amount of incident light to the camera module 3. Therefore, in the present embodiment, the base film 7 is not disposed under the lower electrode 6 in the second display region D2 as illustrated in Fig. 2A. In Figs. 2A and 2B, the base film 7 is referred to as a first film 7b. Fig. 2A illustrates an example in which a second film 7c higher in transmittance than the base film 7 (first film 7b) is disposed under the lower electrode 6 in the second display region D2. As illustrated in Fig. 2C, the second display region D2 faces the camera module 3 disposed on the side of the face 1b opposite to the display face 1a on the substrate of the display device 1.

Fig. 2A illustrates the example in which the second film 7c is disposed under the lower electrode 6 over the entirety of the second display region D2. However, as illustrated in Fig. 2D, the first film 7b may be disposed under the lower electrode 6 in the second display region D2, an opening 7a may be partially provided at the first film 7b, and the second film 7c may be disposed within the opening 7a. The second film 7c in Fig. 2D is disposed on the side of the face 1b opposite to the display face 1a in at least part of the second display region D2, and the part includes a boundary portion between adjacent pixels within the second display region D2.

The opening 7a is provided at least at a boundary portion between pixels. For sufficient incident light to the camera module 3, the ratio of the area of the opening 7a or the second film 7c to the area of the light emitting region within the second display region D2 is desirably 30% or more.

As described later, the second film 7c may have a function of cutting infrared light. Further, the transmittance of the boundary portion between the first film 7b and the second film 7c may vary continuously or stepwise from the first film 7b to the second film 7c.

The first transmittance to visible light having a wavelength of 400 nm is 0 to 50%, for example. The second transmittance to the visible light is 51 to 100%, for example.

On the other hand, in the first display region D1, as illustrated in Fig. 2B, the base film 7 is also disposed at the boundary portion between pixels, and no opening is provided.

This arrangement enables a further increase in the transmittance on the camera module 3 side of the second display region D2 overlapping the disposition place of the camera module 3 and an increase in the amount of incident light to the camera module 3. As a result, the image quality of a shot image can be improved.

The display device 1 according to the present embodiment is characterized in that the transmittance on the camera module 3 side of the second display region D2 is further increased. Hereinafter, a configuration of the display device 1 according to the present embodiment and a manufacturing process thereof will be described. The display device 1 according to the present embodiment is applicable to a display device 1 including an organic electroluminescence (EL) element that performs self-light emission, and is also applicable to a liquid crystal display device 1.

Because a normal camera module 3 mainly images visible light, anything low in transmittance to visible light is often referred to as being opaque. However, in a case where the camera module 3 disposed on the rear face side of the display device 1 images, for example, infrared light, anything low in transmittance to infrared light is opaque.

Thus, the transparent or opaque level and the value of the transmittance are determined in consideration of a balance with the wavelength of light to which the camera module 3 disposed on the rear face side of the display device 1 has detection sensitivity. Hereinafter, mainly on the premise that the camera module 3 for detecting or imaging visible light is disposed on the rear face side of the display device 1, anything high in transmittance to visible light is referred to as being transparent, and anything low in transmittance to visible light is referred to as being opaque.

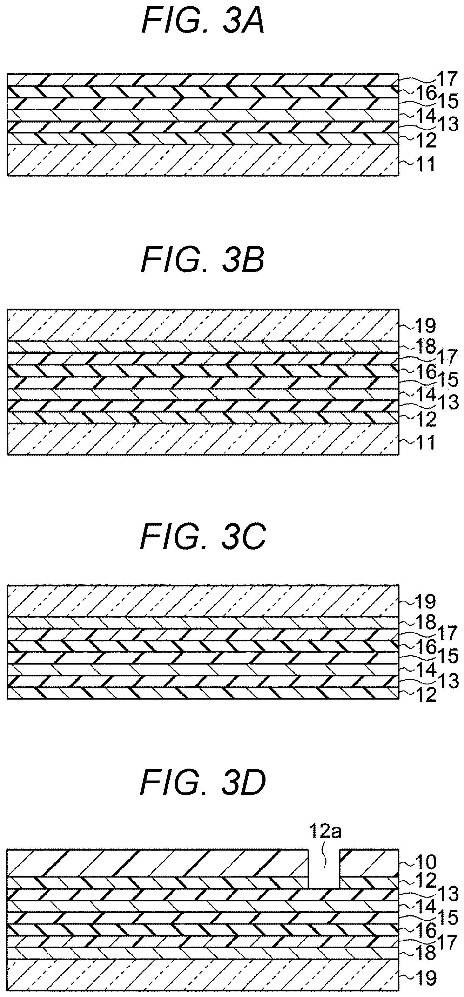

Figs. 3A to 3F are sectional views illustrating a manufacturing process of the display device 1 according to the first embodiment. Figs. 3A to 3F each illustrate a sectional structure of part of the second display region D2 in Fig. 2. Figs. 3A to 3F each illustrate a layered configuration related to the characteristic portion of the display device 1 according to the present embodiment, and there may be a layer not illustrated in the actual display device 1. For example, most of the recent display devices 1 adopt a touch panel type, and a touch sensor layer is provided in the layered configuration of such a display device 1 as above, but is not given in Figs. 3A to 3F. Further, in Figs. 3A to 3F, although the light emitting layer 5 that causes the organic EL element to emit light is illustrated as an EL layer 15, the light emitting layer 5 can include a plurality of layers in practice. Furthermore, although a plurality of TFTs that controls light emission of the organic EL element is illustrated as a TFT layer 14, the TFT layer 14 can include a plurality of layers in practice.

First, as illustrated in Fig. 3A, a base film 12, a first protective film 13, a TFT layer 14, an EL layer 15, a second protective film 16, and transparent film 17 are formed in this order on a glass substrate 11. The base film 12 functions as a sealing material, and usually includes opaque polyimide excellent in heat resistance. The first protective film 13 includes an insulating film high in transmissivity, such as SiN or SiO₂. The TFT layer 14 is formed by implanting impurity ions into, for example, the drain region and the source region, and thermally diffusing the impurity ions. In practice, the EL layer 15 includes a plurality of layers such as an electron injection layer, an electron import layer, a light emitting layer 5, a hole transport layer, a charge generation layer, and an electron import layer. The second protective film 16 includes an insulating film high in transmissivity, such as SiN or SiO₂. The step of Fig. 3A is the same as that of a normal organic EL display device 1.

Among the layers illustrated in Fig. 3A, the opaque layer is the base film 12, and the other layers (excluding a sacrificial layer) each include a material higher in transmittance than the base film 12.

Next, as illustrated in Fig. 3B, a glass substrate 19 is formed above the transparent film 17 with the sacrificial layer 18 interposed therebetween. The sacrificial layer 18 is provided for absorbing laser light to facilitate peeling of the glass substrate 19 in peeling of the glass substrate 19 by laser lift-off in a later step.

Next, as illustrated in Fig. 3C, the glass substrate 11 on the base film 12 is removed to expose the base film 12. The glass substrate 11 may be removed by backgrinding (BGR) or chemical mechanical polishing (CMP). Alternatively, the glass substrate 11 may be peeled off by laser lift-off.

Next, as illustrated in Fig. 3D, a resist 10 is applied onto the exposed base film 12 with the front and rear sides reversed, and then the resist 10 is patterned by lithography. More specifically, an opening 12a is provided at the resist 10 so as to be coincident with the disposition place of a camera module 3. Then, using the resist 10 as a mask, part of the base film 12 at the opening 12a of the resist 10 is etched.

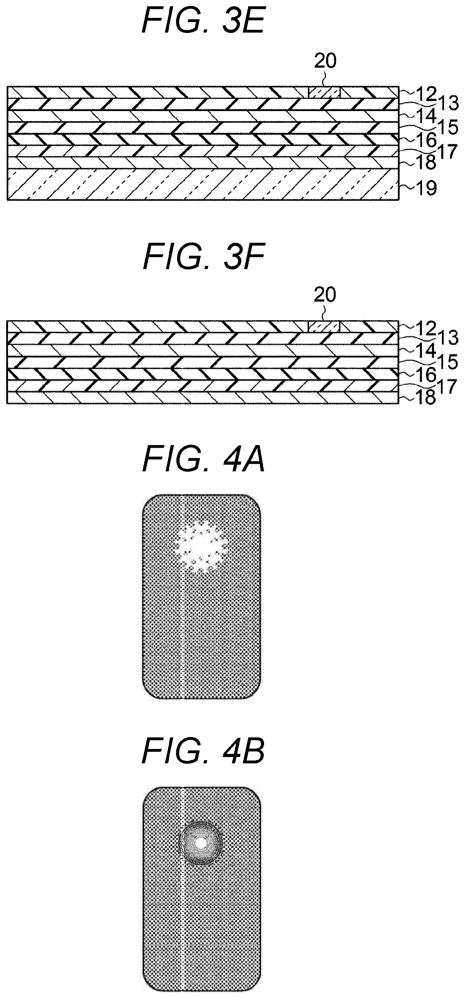

Next, as illustrated in Fig. 3E, the resist 10 is peeled off to expose the base film 12. At the part of the base film 12 (region overlapping the disposition place of the camera module 3) is cut by the etching and the opening 12a is formed. A transmissive member 20 is formed at the opening 12a. The transmissive member 20 may be, for example, transparent polyimide. Note that the transmissive member 20 corresponds to the second film 7c and the base film 12 corresponds to the first film 7b in Fig. 2.

As described above, transparent polyimide is often inferior in heat resistance to the existing opaque polyimide. However, in the present embodiment, only the portion overlapping the camera module 3 includes transparent polyimide. Because the base film 12 itself has heat resistance, a diffusion process can be performed with high heat. Thus, there is no possibility that the electrical characteristics of the TFT formed in the TFT layer 14 are deteriorated.

After the step of Fig. 3E, as illustrated in Fig. 3F, the glass substrate 19 is peeled off by laser lift-off. The laser light emitted to the glass substrate 19 is absorbed by the sacrificial layer 18, and the glass substrate 19 formed on the sacrificial layer 18 can be easily peeled off. As a result, a flexible substrate-shaped display device 1 excellent in flexibility is obtained. Because the display device 1 can be used in a curved shape, its utility value is increased.

After the step of Fig. 3F, the camera module 3 can be attached facing the transmissive member 20 formed at the part of the base film 12. Note that, as described later, various sensor modules other than the camera module 3 may be attached to the rear face side of the display device 1 according to the present embodiment. For example, various biometric-information detection sensors such as a fingerprint sensor may be disposed facing the transmissive member 20 at the base film 12. Hereinafter, structure bodies including the camera module 3 that perform any type of sensing will be collectively referred to as a sensing device.

In the display device 1 fabricated in the manufacturing process of Figs. 3A to 3F, the transmittance (second transmittance) on the sensing device side of the transmissive member 20 formed at the part of the base film 12 is higher than the transmittance (first transmittance) on the sensing device side of the base film 12. The transmissive member 20 formed at the part of the base film 12 can be formed at a boundary portion between pixels of the display device 1. In the present specification, a display region not facing the sensing device is referred to as a first display region D1, and a display region facing the sensing device is referred to as a second display region D2. The transmittance on the side of the face opposite to a display face 1a in the first display region D1 is the first transmittance, and the transmittance on the side of the face (sensing device side) opposite to the display face 1a in the second display region D2 is the second transmittance higher than the first transmittance.

The transmissive member 20 may have not only higher transmittance than the base film 12 but also a function of cutting infrared light. If the transmissive member 20 has a function of cutting infrared light, it is not necessary to provide an infrared-light cut film or the like on the sensing device side, so that the configuration of the sensing device can be simplified.

In a case where the respective transmittances of the base film 12 and the transmissive member 20 are greatly different from each other, there is a possibility that the boundary between the base film 12 and the transmissive member 20 is visually recognized through the display face 1a. Therefore, as illustrated in Fig. 4A or Fig. 4B, the transmittance of the boundary portion between the base film 12 and the transmissive member 20 may vary continuously or stepwise from the base film 12 to the transmissive member 20. In Figs. 4A and 4B, a location low in transmittance is represented in black. Fig. 4A illustrates an example in which the density of a region low in transmittance increases stepwise from the center to the peripheral edge of the transmissive member 20. Fig. 4B illustrates an example in which the transmittance continuously varies from the center to the peripheral edge of the transmissive member 20.

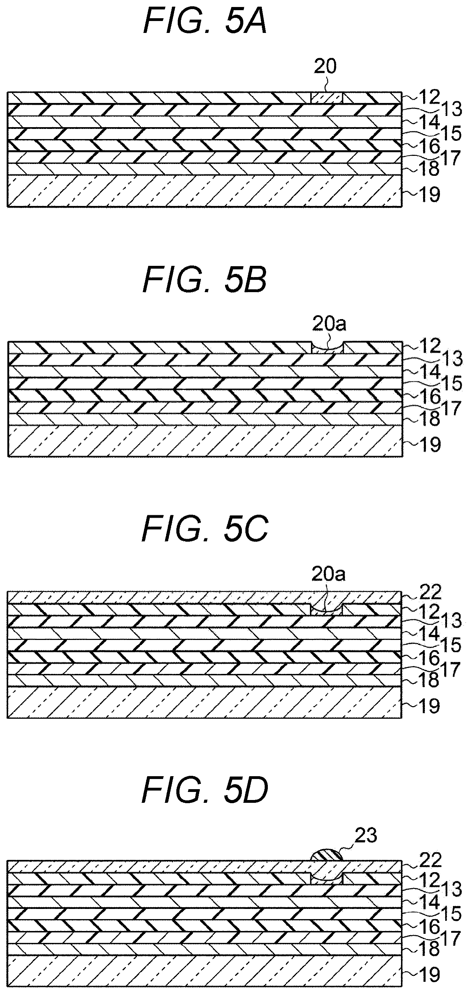

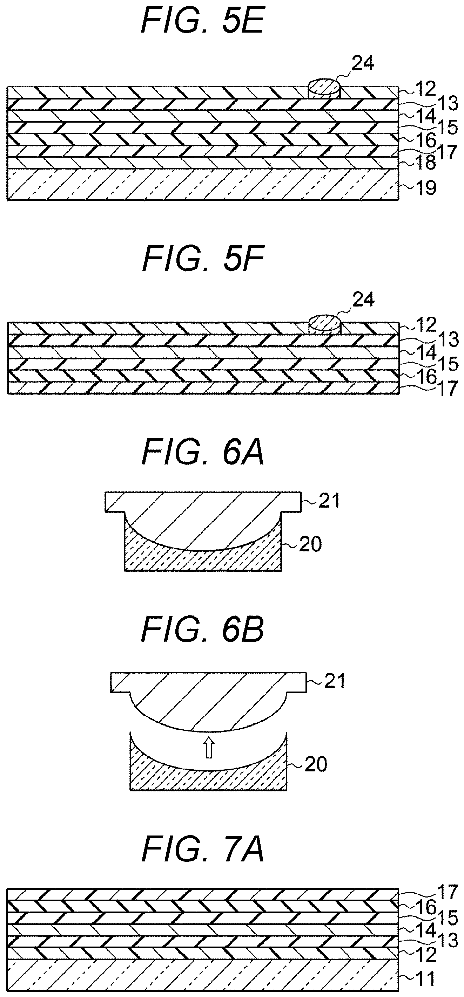

For example, a lens for the camera module 3 can be formed at the transmissive member 20 manufactured in the steps of Figs. 3A to 3E. Figs. 5A to 5F are sectional views illustrating a process of forming a lens at the transmissive member 20. Fig. 5A illustrates a sectional structure similar to that in Fig. 3E. Next, as illustrated in Fig. 5B, part of the transmissive member 20 formed at the part of the base film 12 is removed to form a concave portion 20a. The concave portion 20a can be formed by, for example, etching or imprinting. Figs. 6A and 6B are explanatory views schematically illustrating an exemplary procedure of an imprinting process. First, as illustrated in Fig. 6A, under pressing with a master plate 21 for imprinting, the front face of the transmissive member 20 is subjected to heating or is irradiated with light, so that the outer shape of the master plate 21 is transferred to the transmissive member 20. Next, the master plate 21 is released, and heat treatment, light irradiation, or the like is performed. As a result, the front-face shape of the transmissive member 20 can be formed into a shape corresponding to the outer shape of a lens.

In such a manner, the imprinting process is performed to form at least one of a concave portion or a convex portion on the front face of the transmissive member 20.

After the step of Fig. 5B is completed, next, as illustrated in Fig. 5C, a transparent resin layer 22 is formed on the base film 12 including the inside of the above concave portion 20a in a process similar to a manufacturing process of an on-chip lens of a complementary metal oxide semiconductor (CMOS) image sensor.

Next, as illustrated in Fig. 5D, a resist 23 is applied onto the transparent resin layer 22 and patterned to leave the resist 23 only immediately above the transmissive member 20. Next, as illustrated in Fig. 5E, the transparent resin layer 22 is partially removed by etching using the resist 23 as a mask, and then the resist 23 is removed. As a result, a lens 24 includes the transparent resin layer 22 at the part of the transmissive member 20. The lens 24 is, for example, a convex lens. The transmissive member 20 is subjected to the front-face processing in Fig. 5B and the resist 23 is patterned in Fig. 5D so as to fit the outer shape of the lens 24. Thus, a lens having a desired outer shape can be formed.

Next, as illustrated in Fig. 5F, similarly to Fig. 3F, the glass substrate 19 is peeled off by, for example, laser lift-off, so that a flexible substrate-shaped display device 1 with the lens is obtained. This lens can be used to collect light to a sensing device such as the camera module 3.

In Figs. 5A to 5F, the example in which the front face of the transmissive member 20 is processed to form the convex lens has been described. The transmissive member 20, however, can be processed into various shapes by using, for example, an imprinting process. For example, the transmissive member 20 can also be processed to form a moth-eye structure layer having fine bumps. The moth-eye structure layer has a function of suppressing reflection. Thus, for example, due to disposition of the moth-eye structure layer between the light emitting layer 5 and the lens of the camera module 3, the amount of incident light to the lens can be increased and a shot image quality can be improved.

As described above, in the first embodiment, the opening 12a is provided at the part of the base film 12 including opaque polyimide so as to be coincident with the disposition place of the sensing device such as the camera module 3, and the transmissive member 20 is formed at the opening 12a. Therefore, sufficient light can be guided to the sensing device through the transmissive member 20, so that the detection sensitivity of the sensing device can be improved.

### (Second Embodiment)

In the first embodiment, the transmissive member 20 is formed at the opening 12a formed at the part of the base film 12, but the opening 12a may be left. Even if the opening 12a is left, that is, the transmissive member 20 is not disposed inside the opening 12a, the transmittance on the sensing device side of the opening 12a is higher than the transmittance on the sensing device side of the base film 12. Therefore, due to disposition of the sensing device facing the opening 12a, the amount of incident light to the sensing device is increased.

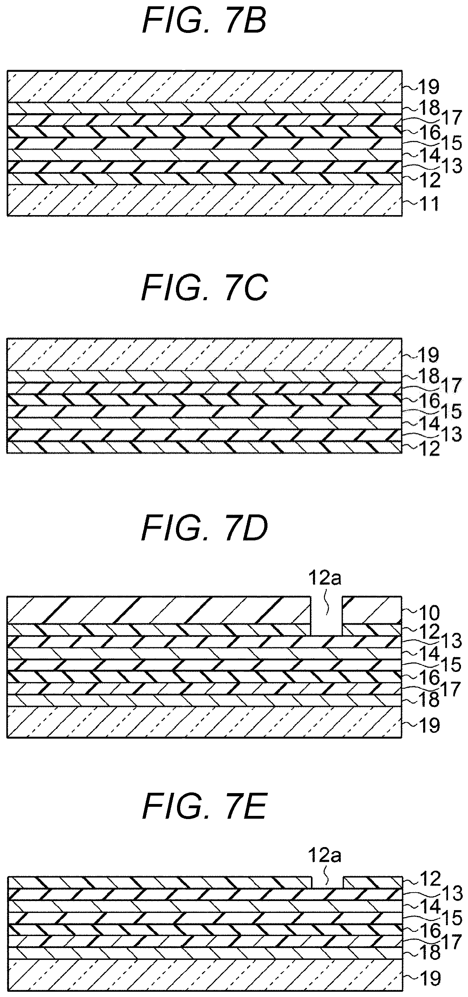

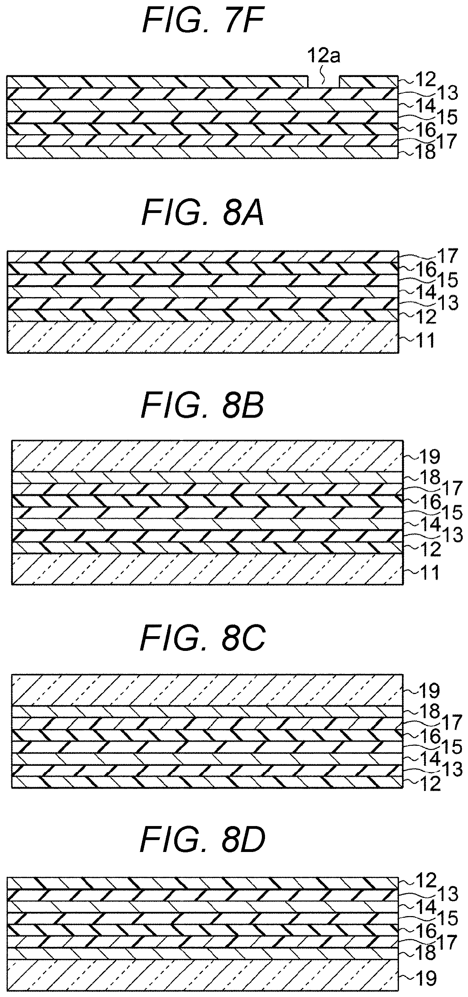

Figs. 7A to 7F are sectional views illustrating a manufacturing process of a display device 1 according to a second embodiment. Figs. 7A to 7D are the same as Figs. 3A to 3D. In Fig. 3E, the opening 12a is formed at the exposed base film 12 so as to be coincident with the disposition place of the sensing device, and the transmissive member 20 is formed at the opening 12a. However, in Fig. 7E, an opening 12a is formed and left, and a transmissive member 20 is not formed within the opening 12a. Next, as illustrated in Fig. 7F, a glass substrate 19 is peeled off by laser lift-off, so that a flexible substrate-shaped display device 1 excellent in flexibility can be obtained.

After the step of Fig. 7F, a sensing device such as a camera module 3 is disposed facing the opening 12a formed at part of the base film 12, or in order to protect a base film 12, the front face of the base film 12 may be covered with a protective film having transmissivity while leaving the opening 12a. In this case, the opening 12a becomes a void sealed with the base film 12 and the protective film, so that high transmissivity is maintained.

As described above, in the second embodiment, the opening 12a is formed at the part of the base film 12 so as to be coincident with the disposition place of the sensing device. Thus, sufficient light can be incident to the sensing device through the opening 12a. Because the step of forming another member at the opening 12a can be omitted, the manufacturing process can be simplified as compared with the first embodiment.

### (Third Embodiment)

In a third embodiment, a base film 12 including polyimide is removed after the process of applying heat in fabrication of a display device 1 is completed.

The reason for using opaque polyimide as the base film 12 of a display device 1 is that opaque polyimide is excellent in heat resistance. In the display device 1, it is necessary to form a TFT layer 14 using polysilicon or the like, and diffusion treatment of impurity ions is essential for the formation of the TFT layer 14. In the diffusion treatment, heat treatment is performed. Thus, for example, in a case where transparent polyimide is used as a base film 12, too high heat cannot be applied thereto. Thus, there is a possibility that the electrical characteristics of the TFT are deteriorated.

Therefore, in the present embodiment, the base film 12 using opaque polyimide is formed until the step of applying heat in the fabrication of the display device 1 is completed, and the base film 12 is peeled off after the step of applying heat is completed.

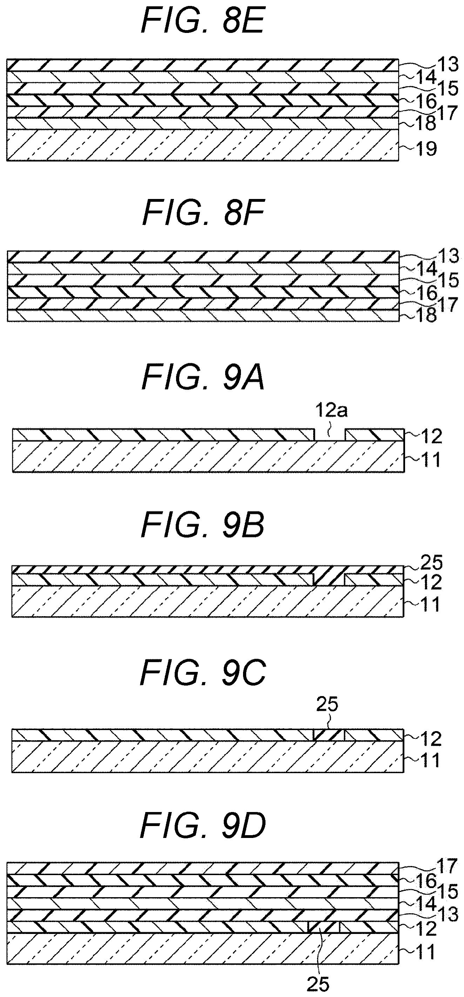

Figs. 8A to 8F are sectional views illustrating a manufacturing process of the display device 1 according to the third embodiment. Figs. 8A to 8C are the same as Figs. 3A to 3C. As illustrated in Fig. 8D, at the stage where a glass substrate 11 is removed (peeled off) to expose the base film 12, a TFT layer 14 and an EL layer 15 are already formed. Thus, there is no subsequent step of applying high heat. Therefore, as illustrated in Fig. 8E, the base film 12 is removed by etching or the like. At this time, a protective film including, for example, SiN is used as an etching stopper layer. Next, as illustrated in Fig. 8F, a glass substrate 19 is peeled off by laser lift-off.

In a case where the protective function and sealing function of the display device 1 become insufficient due to the removal of the base film 12, a transparent resin layer 22 or the like may be disposed on the protective film.

As described above, in the third embodiment, the base film 12 including opaque polyimide is formed until the step of applying heat in the fabrication of the display device 1 is completed, and the base film 12 is removed after the step of applying heat is completed. In such a manner, the transmittance of the entirety of a second display region D2 can be increased, so that sufficient light can be incident to a sensing device.

### (Fourth Embodiment)

A fourth embodiment is different from the first to third embodiments in the order of steps of forming an opening 12a at part of a base film 12.

Figs. 9A to 9G are sectional views illustrating a manufacturing process of a display device 1 according to the fourth embodiment. First, as illustrated in Fig. 9A, the base film 12 including opaque polyimide is formed on a glass substrate 11, and then the opening 12a is formed at the base film 12 so as to be coincident with the disposition place of a sensing device. Here, for example, a resist is applied onto the base film 12 and patterned, and the opening 12a is formed by etching.

Next, as illustrated in Fig. 9B, the upper face of the base film 12 including the inside of the opening 12a is covered with an insulating film 25 high in transmissivity, such as SiO₂ or SiN. Next, as illustrated in Fig. 9C, the insulating film 25 formed on the upper face of the base film 12 is removed by, for example, CMP to expose the base film 12 and the insulating film 25 within the opening 12a.

Next, as illustrated in Fig. 9D, a first protective film 13, a TFT layer 14, an EL layer 15, a second protective film 16, and a transparent film 17 are formed in this order on the base film 12.

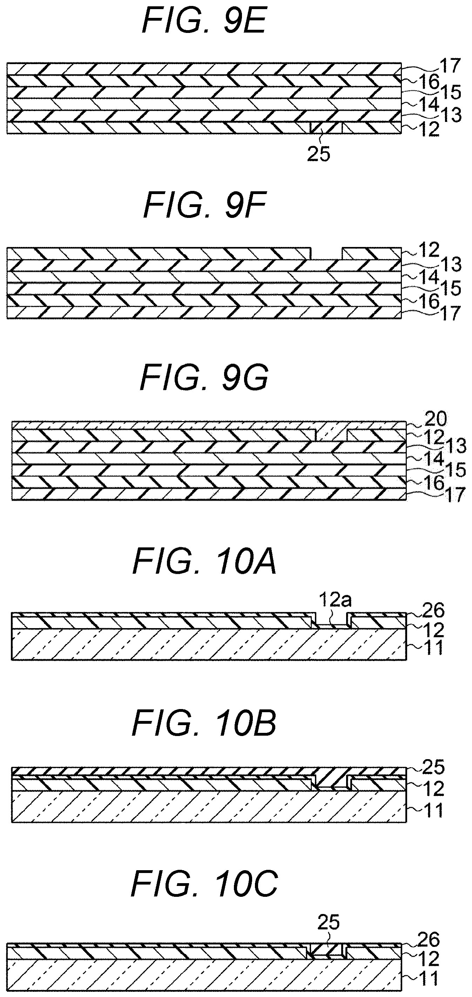

Next, as illustrated in Fig. 9E, the glass substrate 11 is removed (peeled off) by, for example, etching or laser lift-off to expose the base film 12.

Next, as illustrated in Fig. 9F, the insulating film 25 formed inside the opening 12a of the base film 12 is removed by, for example, etching. At this time, the second protective film 16 under the base film 12 functions as an etching stopper layer.

Next, as illustrated in Fig. 9G, the entire upper face of the base film 12 including the inside of the opening 12a is covered with a transmissive member 20. As a result, a flexible substrate-shaped display device 1 is obtained.

In Figs. 9A to 9G, the opening 12a is formed within the base film 12 at the initial stage of the manufacturing process of the display device 1. With the insulating film 25 high in heat resistance formed within the opening 12a, the layers of the display device 1 are each formed in the above order. Finally, the insulating film 25 within the opening 12a is replaced with the original transmissive member 20.

In the above step of Fig. 9C, the insulating film 25 is removed by, for example, CMP to expose the base film 12 and the insulating film 25 within the opening 12a. A stopper layer may be provided in advance on the upper face of the base film 12.

Figs. 10A to 10C are sectional views of steps performed instead of those of Figs. 9B and 9C. First, as illustrated in Fig. 9A, an opening 12a is formed at part of a base film 12. Then, as illustrated in Fig. 10A, the upper face of the base film 12 including an inner wall portion of the opening 12a is covered with a stopper layer 26. The stopper layer 26 is formed by, for example, atomic layer deposition (ALD), or chemical vapor deposition (CVD).

Next, as illustrated in Fig. 10B, an insulating film 25 is formed on the stopper layer 26. Next, the insulating film 25 on the stopper layer 26 is removed by etching to expose the stopper layer 26 and the insulating layer 25 within the opening 12a.

As described above, in the fourth embodiment, the opening 12a is formed at the base film 12 at the initial stage of the manufacturing process of the display device 1. Thus, it is not necessary to dispose an etching stopper layer 26 or the like under the base film 12, and the opening 12a can be formed easily. Further, the temporary insulating film 25 high in heat resistance is formed at the opening 12a and the insulating film 25 is replaced with the transmissive member 20 at the final stage. Thus, high heat can be applied at the time of manufacturing the display device 1, so that the display device 1 excellent in electrical characteristics can be fabricated.

### (Fifth Embodiment)

In the display device 1 according to any of the first to fourth embodiments described above, various sensing devices can be disposed facing the opening 12a formed at the part of the base film 12. Hereinafter, an example in which a fingerprint sensor that does not require a lens is disposed will be described as an exemplary sensing device for detecting biometric information.

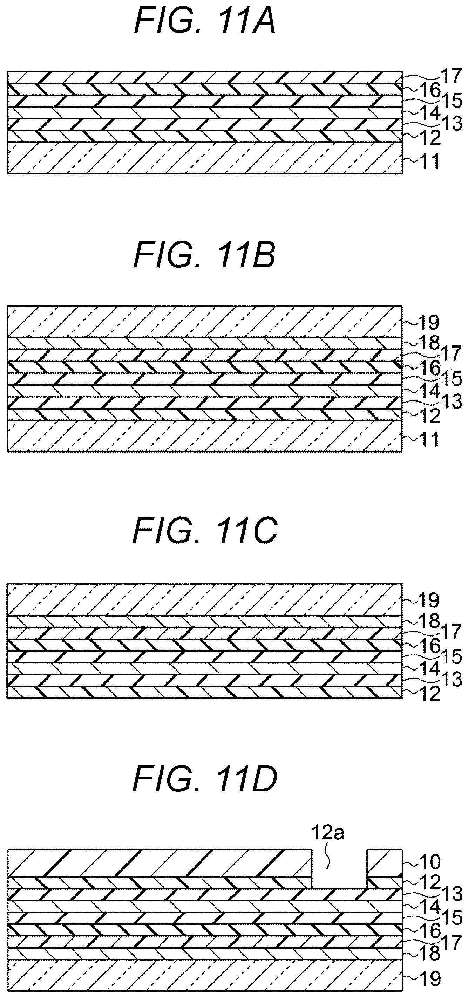

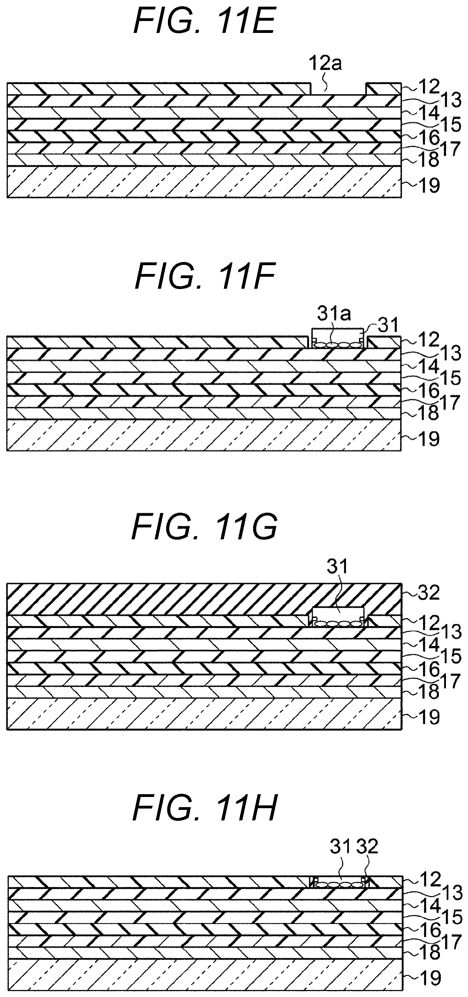

Figs 11A to 11J are sectional views illustrating a manufacturing process of a display device 1 according to a fifth embodiment. Figs. 11A to 11E are similar to Figs. 7A to 7E. However, in the present embodiment, it is assumed that a fingerprint sensor 31 is disposed. Thus, the opening size of an opening 12a formed at part of a base film 12 is a size in agreement with the outer shape of the fingerprint sensor 31. More specifically, the opening size of the opening 12a needs to be larger than the outer size of the fingerprint sensor 31.

Next, as illustrated in Fig. 11F, the fingerprint sensor 31 is formed within the opening 12a formed at the part of the base film 12. The fingerprint sensor 31 does not require a lens on its outside, but an inner lens 31a is provided inside the fingerprint sensor 31.

As described above, the opening size of the opening 12a formed at the part of the base film 12 is larger than the outer size of the fingerprint sensor 31. Thus, when the fingerprint sensor 31 is disposed inside the opening 12a, a gap is formed between the inner wall face of the opening 12a and the outer wall face of the fingerprint sensor 31. Therefore, as illustrated in Fig. 11G, an adhesive layer or an insulating film 32 is formed on the entire upper face of the base film 12 including the gap. The insulating film 32 in this case is, for example, SiO₂ or SiN.

Next, as illustrated in Fig. 11H, the adhesive layer or the insulating film 32 is removed by, for example, CMP or etching to expose the base film 12. As a result, the adhesive layer or the insulating film 32 fills between the inner wall face of the opening 12a and the outer wall face of the fingerprint sensor 31.

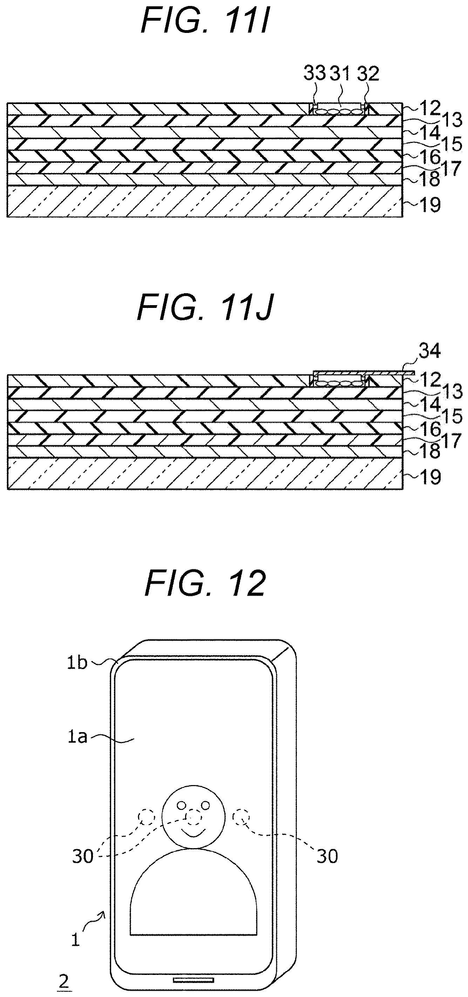

Next, as illustrated in Fig. 11I, the adhesive layer or the insulating film 32 formed on a pad portion 33 of the fingerprint sensor 31 is removed by lithography and etching to expose the pad portion 33. Next, as illustrated in Fig. 11J, a bonding wire 34 is connected to the pad portion 33 of the fingerprint sensor 31 to make wiring connection.

As described above, in the fifth embodiment, the sensing device can be directly disposed at the opening 12a formed at the part of the base film 12.

### (Sixth Embodiment)

In a sixth embodiment, a plurality of sensing devices is disposed opposite a display face 1a of a display device 1.

Fig. 12 is a plan view of an electronic apparatus 2 according to the sixth embodiment. In the electronic apparatus 2 in Fig. 12, three sensing devices 30 are disposed opposite the display face 1a of the display device 1. Note that the number of sensing devices 30 is not limited to three. Further, a target to be sensed by such a sensing device 30 described above is optional. For example, all the three sensing devices 30 may be camera modules and different in focal length. Alternatively, a camera module and two biometric-information-detection sensing devices may be disposed in combination.

An opening 12a is formed at a base film 12 of the display device 1 corresponding to each of the sensing devices 30. A transmissive member 20 may be disposed at the opening 12a, or may be left. There is a possibility that the optimum light amount of incident light differs depending on the type of a sensing device 30. Thus, in order to dispose a transmissive member 20 at the opening 12a, it is desirable to set the transmittance of the transmissive member 20 to a value corresponding to each sensing device 30.

As described above, in the sixth embodiment, the plurality of types of sensing devices 30 is disposed on the rear face side of the display device 1, and the transmittance of the transmissive member 20 disposed at a place overlapping each sensing device 30 is optimized individually. As a result, the detection sensitivity of all the sensing devices 30 can be improved.

### (Seventh Embodiment)

In an electronic apparatus 2 according to a seventh embodiment, an optical system of a camera module 3 is different from those of the first to sixth embodiments.

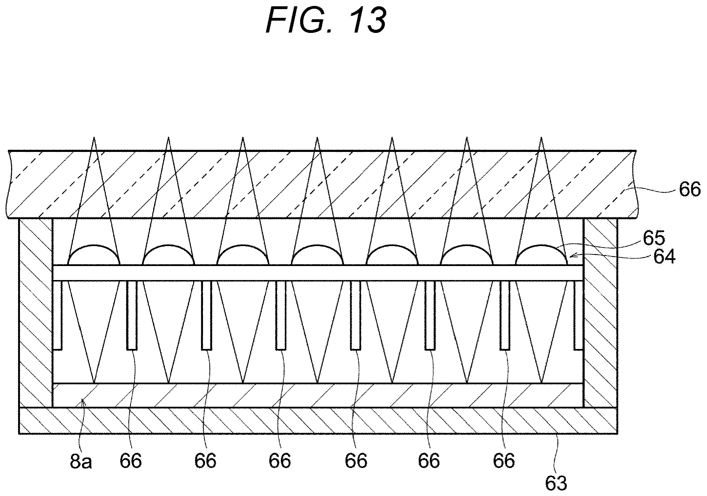

Fig. 13 illustrates a sectional structure of an imaging unit of the camera module 3 with which the electronic apparatus 2 according to the seventh embodiment is equipped. The imaging unit in Fig. 13 includes a microlens array 64 that is not a single lens or a lens group including each single lens arranged in its optical axis direction.

More specifically, the imaging unit in Fig. 13 includes a photoelectric conversion unit 4a disposed along the bottom face of a casing 63, the microlens array 64 disposed above the photoelectric conversion unit 4a, a plurality of light blocking bodies 66 disposed between adjacent microlenses 65, and a light guide plate 67 disposed above the microlens array 64. The imaging unit in Fig. 13 is applicable to any of the first to eighth embodiments described above.

### (Eighth Embodiment)

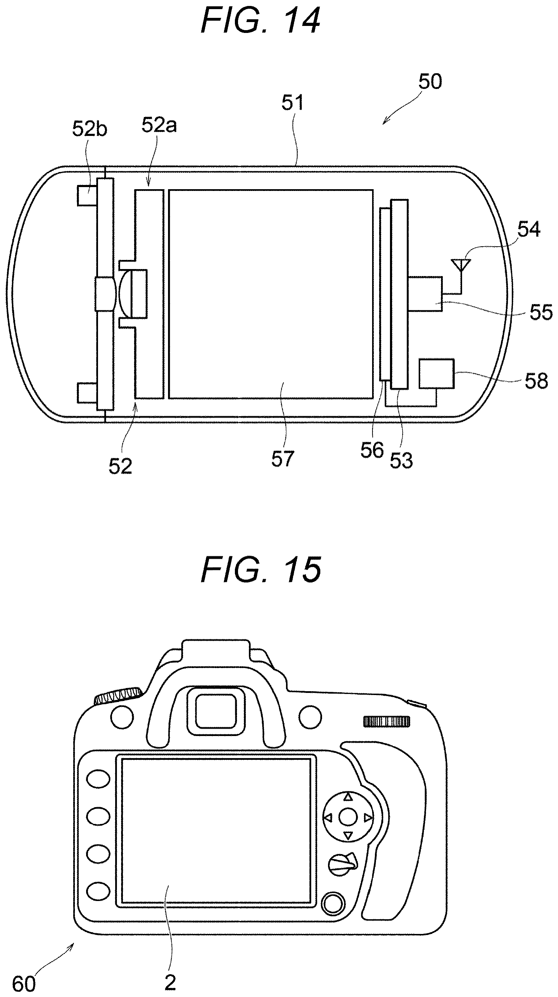

As a specific candidate for the electronic apparatus 2 having the configuration described in any of the first to seventh embodiments, various candidates are conceivable. For example, Fig. 14 is a plan view of a capsule endoscope 50 to which the electronic apparatus 2 according to any of the first to seventh embodiments is applied. The capsule endoscope 50 in Fig. 14 includes, in a casing 51 having, for example, hemispherical both end faces and a cylindrical central portion, a camera (ultra-small camera) 52 for shooting an image of the inside of a body cavity, a memory 53 for recording data of the image shot by the camera 52, and a wireless transmitter 55 for transmitting the recorded data of the image to the outside through an antenna 54 after the capsule endoscope 50 is discharged to the outside of the subject.

Further, within the casing 51, a central processing unit (CPU) 56 and a coil (magnetic force/current conversion coil) 57 are provided. The CPU 56 controls shooting by the camera 52 and data accumulation operation into the memory 53, and controls data transmission from the memory 53 to a data receiving device (not illustrated) outside the casing 51 by the wireless transmitter 55. The coil 57 supplies power to the camera 52, the memory 53, the wireless transmitter 55, the antenna 54, and a light source 52b to be described later.

Further, the casing 51 is provided with a magnetic (reed) switch 58 for sensing setting in the setting of the capsule endoscope 50 in the data receiving device. The CPU 56 supplies power from the coil 57 to the wireless transmitter 55 at the time when the reed switch 58 senses the setting to the data receiving device and data transmission becomes possible.

The camera 52 includes, an imaging element 52a, for example, including an objective optical system for shooting an image of the inside of a body cavity and a plurality of light sources 52b for illuminating the inside of the body cavity. Specifically, the camera 52 includes, as such a light source 52b described above, for example, a complementary metal oxide semiconductor (CMOS) sensor provided with a light emitting diode (LED), or a charge coupled device (CCD).

The display device 1 in the electronic apparatus 2 according to any of the first to seventh embodiments is a concept including a light emitter such as the light source 52b in Fig. 14. The capsule endoscope 50 in Fig. 14 includes two light sources 52b, for example. These light sources 52b, however, can be configured by a display panel having a plurality of light source units or an LED module having a plurality of LEDs. In this case, disposition of an imaging unit of the camera 52 below the display panel or the LED module reduces restrictions on the layout of the camera 52, results in achievement of a capsule endoscope 50 smaller in size.

Further, Fig. 15 is a rear view of a digital single-lens reflex camera 60 to which the electronic apparatus 2 according to any of the first to seventh embodiments is applied. The digital single-lens reflex camera 60 or a compact camera includes a display device 1 for displaying a preview screen on the rear face opposite the lens. A camera module 3 may be disposed opposite a display face of the display device 1 such that a facial image of the shooter can be displayed on the display face 1a of the display device 1. In the electronic apparatus 2 according to any of the first to seventh embodiments, the camera module 3 can be disposed in the region overlapping the display device 1. Thus, it is not necessary to provide the camera module 3 in the frame portion of the display device 1, and the size of the display device 1 can be increased as much as possible.

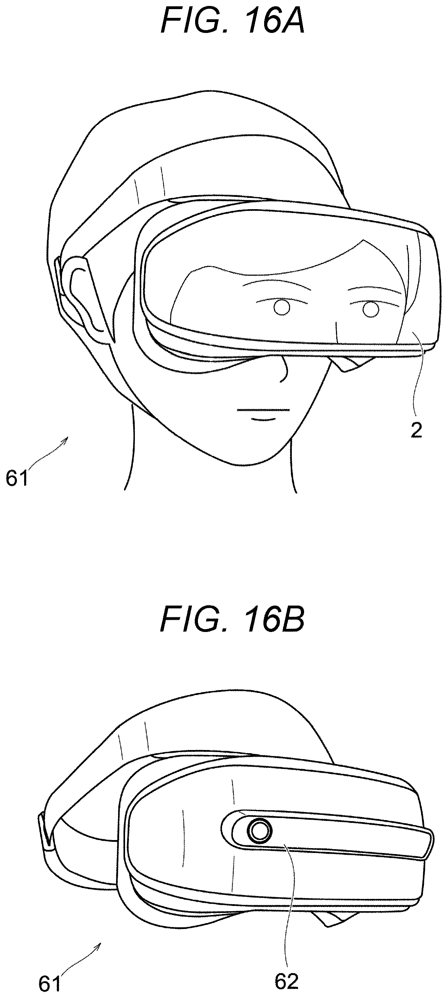

Fig. 16A is a plan view illustrating an example in which the electronic apparatus 2 according to any of the first to seventh embodiments is applied to a head-mounted display (HMD) 61. The HMD 61 in Fig. 16A is used for virtual reality (VR), augmented reality (AR), mixed reality (MR), substituional reality (SR), or the like. As illustrated in Fig. 16B, the current HMD is equipped with a camera 62 on its outer front face. Thus, there is a disadvantage that the wearer of the HMD can visually recognize the surrounding image but a person around the wearer cannot recognize the eyes or facial expression of the wearer of the HMD.

Therefore, in Fig. 16A, a display face of a display device 1 is provided on the outer front face of the HMD 61, and a camera module 3 is provided opposite the display face of the display device 1. As a result, the facial expression of the wearer shot by the camera module 3 can be displayed on the display face of the display device 1, and the person around the wearer can grasp the facial expression and eye movement of the wearer in real time.

In the case of Fig. 16A, the camera module 3 is provided on the rear face side of the display device 1. Thus, there is no restriction on the installation place of the camera module 3, resulting in an increase in the degree of freedom in the design of the HMD 61. Further, the camera can be disposed at an optimum position. Thus, it can prevent problems such as misalignment of the eyes of the wearer displayed on the display face.

As described above, in the eighth embodiment, the electronic apparatus 2 according to any of the first to seventh embodiments can be used for various applications, and its utility value can be increased.

The invention is defined in the appended claims.

### REFERENCE SIGNS LIST

- 1: Display device
- 1a: Display face
- 2: Electronic apparatus
- 3: Camera module
- 4: Upper electrode
- 5: Light emitting layer
- 6: Lower electrode
- 7: Base film
- 7a: Opening
- 7b: First film
- 7c: Second film
- 10: Resist
- 11: Glass substrate
- 12: Base film
- 13: First protective film
- 14: TFT layer
- 15: EL layer
- 16: Second protective film
- 17: Transparent film
- 18: Sacrificial layer
- 19: Glass substrate
- 20: Transmissive member
- 20a: Concave portion
- 21: Master plate
- 22: Transparent resin layer
- 23: Resist
- 24: Lens
- 25: Insulating film
- 26: Stopper layer
- 31: Fingerprint sensor
- 31a: Inner lens32 Adhesive layer or insulating film
- 33: Pad portion
- 34: Bonding wire
- 50: Capsule endoscope
- 51: Casing
- 52: Camera
- 53: Memory
- 54: Antenna
- 55: Wireless transmitter
- 60: Digital single-lens camera
- 61: Head-mounted display
- 64: Microlens array
- 65: Microlens
- 66: Light blocking body

## Claims

1. A display device (1) comprising:
a substrate (4, 5, 6);
a first display region (D1) disposed on the substrate (4,5,6), the first display region (D1) having a plurality of pixels; and
a second display region (D2) disposed on the substrate (4, 5, 6), the second display region (D2) having a plurality of pixels,
wherein the substrate (4,5,6) has a first transmittance in the first display region (D1),
the substrate (4, 5, 6) has a second transmittance in the second display region (D2) higher than the first transmittance,
the second display region (D2) faces a sensing device (3) disposed on a side of a face opposite to a display face (1a) on the substrate (4,5,6),
a first film (7b, 12) is disposed on the side of the face opposite to the display face within the first display region (D1) and has the first transmittance,
the first film (7b, 12) is provided in at least part of the second display region (D2), the at least part excluding a boundary portion between adjacent pixels within the second display region (D2), and
an opening (7a, 12a) of the first film (7b, 12) is provided at the boundary portion between the adjacent pixels within the second display region (D2).

2. The display device according to claim 1, further comprising: a second film (7c, 20) disposed on the side of the face opposite to the display face within the second display region, the second film having the second transmittance.

3. The display device according to claim 1 or 2, wherein a ratio of an area of the second film to an area of a light emitting region within the second display region is 30% or more.

4. The display device according to any of claims 1 to 3, wherein the second film has a function of cutting infrared light.

5. The display device according to any of claims 1 to 4,
wherein the second film is disposed at the opening formed by removal of part of the first film, and
a transmittance of a boundary portion between the first film and the second film varies continuously or stepwise from the first film to the second film.

6. The display device according to any of claims 1 to 5,
wherein the first film contains polyimide, and
the second film contains a material higher in transmittance than the polyimide of the first film.

7. The display device according to any of claims 1 to 6, wherein the second film has at least one of a concave portion (20a) or a convex portion, and the display device further comprises:
an optical lens (24) including the second film, or a moth-eye structure layer including the second film.

8. An electronic apparatus comprising:
the display device according to any one of the claims 1 to 7; and
the sensing device disposed opposite a display face of the display device.

9. The electronic apparatus according to claim 8, wherein the sensing device includes an imaging sensor.

10. The electronic apparatus according to claim 8, wherein the sensing device includes a biometric-information detection sensor.

11. The electronic apparatus according to any one of claims 8 to 10, wherein
a plurality of the second display regions is provided on the display face, and
a plurality of the sensing devices is disposed corresponding to the plurality of the second display regions.

12. The electronic apparatus according to claim 11, wherein the respective second transmittances of at least two of the plurality of the second display regions are different from each other.

13. A method for manufacturing a display device (1), the method comprising:
forming a first film (12, 7b) having a first transmittance on a first support substrate (11);
forming a light emitting layer (15) on the first film (12, 7b);
forming a protective film (13) on the light emitting layer (15);
forming a second support substrate (19) on the protective film (13);
removing the first support substrate (19);
forming an opening (12a, 7a) at the first film (12, 7b) in accordance with a disposition place of a sensing device (3), wherein
forming the first film (12, 7b) in at least part of a region (D2) facing the sensing device (3), the at least part excluding a boundary portion between adjacent pixels within the region (D2) facing the sensing device (3), and
forming the opening (12a, 7a) of the first film (12, 7b) at the boundary portion between the adjacent pixels within the region facing the sensing device (3).

14. A method for manufacturing a display device (1), the method comprising:
forming a first film (12, 7b) having a first transmittance on a support substrate (11);
forming an opening (12a, 7a) at the first film so as to be coincident with a disposition place of a sensing device (3);
filling the openings with an insulating member (25);
forming a first protective film (13) on the first film;
forming a light emitting layer (15) on the first protective film;
forming a second protective film (16) on the light emitting layer;
removing the insulating member to form the openings at the first film, wherein
forming the first film in at least part of a region (D2) facing the sensing device, the at least part excluding a boundary portion between adjacent pixels within the region facing the sensing device, and
forming the opening of the first film at the boundary portion between the adjacent pixels within the region facing the sensing device.

## Patentansprüche

1. Anzeigevorrichtung (1), umfassend:
ein Substrat (4, 5, 6);
einen ersten Anzeigebereich (D1), der auf dem Substrat (4, 5, 6) angeordnet ist, wobei der erste Anzeigebereich (D1) eine Vielzahl von Pixeln aufweist; und
einen zweiten Anzeigebereich (D2), der auf dem Substrat (4, 5, 6) angeordnet ist, wobei der zweite Anzeigebereich (D2) eine Vielzahl von Pixeln aufweist,
wobei das Substrat (4, 5, 6) im ersten Anzeigebereich (D1) eine erste Durchlässigkeit aufweist, das Substrat (4, 5, 6) in dem zweiten Anzeigebereich (D2) eine zweite Durchlässigkeit aufweist, die höher ist als die erste Durchlässigkeit, der zweite Anzeigebereich (D2) einer Erfassungsvorrichtung (3) zugewandt ist, die auf einer Seite einer Fläche gegenüber einer Anzeigefläche (1a) auf dem Substrat (4, 5, 6) angeordnet ist,
ein erster Film (7b, 12) auf der Seite der Fläche gegenüber der Anzeigefläche innerhalb des ersten Anzeigebereichs (D1) angeordnet ist und die erste Durchlässigkeit aufweist,
der erste Film (7b, 12) in mindestens einem Teil des zweiten Anzeigebereichs (D2) bereitgestellt ist, wobei der mindestens eine Teil einen Grenzbereich zwischen benachbarten Pixeln innerhalb des zweiten Anzeigebereichs (D2) ausschließt, und
eine Öffnung (7a, 12a) des ersten Films (7b, 12) an dem Grenzabschnitt zwischen den benachbarten Pixeln innerhalb des zweiten Anzeigebereichs (D2) bereitgestellt ist.

2. Anzeigevorrichtung nach Anspruch 1, ferner umfassend: einen zweiten Film (7c, 20), der auf der Seite der Fläche gegenüber der Anzeigefläche innerhalb des zweiten Anzeigebereichs angeordnet ist, wobei der zweite Film die zweite Durchlässigkeit aufweist.

3. Anzeigevorrichtung nach Anspruch 1 oder 2, wobei das Verhältnis der Fläche des zweiten Films zur Fläche eines lichtemittierenden Bereichs innerhalb des zweiten Anzeigebereichs 30 % oder mehr beträgt.

4. Anzeigevorrichtung nach einem der Ansprüche 1 bis 3, wobei die zweite Folie eine Funktion zum Schneiden von Infrarotlicht aufweist.

5. Anzeigevorrichtung nach einem der Ansprüche 1 bis 4,
wobei der zweite Film an der durch Entfernen eines Teils des ersten Films gebildeten Öffnung angeordnet ist, und
sich eine Durchlässigkeit eines Grenzabschnitts zwischen dem ersten Film und dem zweiten Film kontinuierlich oder stufenweise vom ersten Film zum zweiten Film ändert.

6. Anzeigevorrichtung nach einem der Ansprüche 1 bis 5,
wobei der erste Film Polyimid enthält, und
der zweite Film ein Material mit höherer Durchlässigkeit als das Polyimid des ersten Films enthält.

7. Anzeigevorrichtung nach einem der Ansprüche 1 bis 6,
wobei der zweite Film mindestens einen konkaven Abschnitt (20a) oder einen konvexen Abschnitt aufweist, und die Anzeigevorrichtung ferner umfasst:
eine optische Linse (24) einschließlich des zweiten Films, oder eine Mottenaugenstrukturschicht einschließlich des zweiten Films.

8. Elektronische Einrichtung, umfassend:
die Anzeigevorrichtung nach einem der Ansprüche 1 bis 7; und
die Erfassungsvorrichtung, die gegenüber einer Anzeigefläche der Anzeigevorrichtung angeordnet ist.

9. Elektronische Einrichtung nach Anspruch 8, wobei die Sensorvorrichtung einen Bildsensor einschließt.

10. Elektronische Einrichtung nach Anspruch 8, wobei die Erfassungsvorrichtung einen Sensor zur Erkennung biometrischer Informationen einschließt.

11. Elektronische Einrichtung nach einem der Ansprüche 8 bis 10, wobei
eine Vielzahl der zweiten Anzeigebereiche auf der Anzeigefläche bereitgestellt ist, und
eine Vielzahl der Erfassungsvorrichtungen gemäß der Vielzahl der zweiten Anzeigebereiche angeordnet ist.

12. Elektronische Einrichtung nach Anspruch 11, wobei sich die jeweiligen zweiten Durchlässigkeiten von mindestens zwei der Vielzahl der zweiten Anzeigebereiche voneinander unterscheiden.

13. Verfahren zum Herstellen einer Anzeigevorrichtung (1), das Verfahren umfassend:
Bilden eines ersten Films (12, 7b) mit einer ersten Durchlässigkeit auf einem ersten Trägersubstrat (11);
Bilden einer lichtemittierenden Schicht (15) auf dem ersten Film (12, 7b);
Bilden eines Schutzfilms (13) auf der lichtemittierenden Schicht (15);
Bilden eines zweiten Trägersubstrats (19) auf dem Schutzfilm (13);
Entfernen des ersten Trägersubstrats (19);
Bilden einer Öffnung (12a, 7a) in dem ersten Film (12, 7b) gemäß einer Anordnungsstelle einer Sensorvorrichtung (3), wobei
der erste Film (12, 7b) in mindestens einem Teil eines Bereichs (D2), der der Sensorvorrichtung (3) zugewandt ist, gebildet wird, wobei der mindestens eine Teil einen Grenzabschnitt zwischen benachbarten Pixeln innerhalb des Bereichs (D2), der der Sensorvorrichtung (3) zugewandt ist, ausschließt, und
die Öffnung (12a, 7a) des ersten Films (12, 7b) in dem Grenzabschnitt zwischen den benachbarten Pixeln innerhalb des dem Sensor (3) zugewandten Bereichs gebildet wird.

14. Verfahren zum Herstellen einer Anzeigevorrichtung (1), das Verfahren umfassend:
Ausbilden eines ersten Films (12, 7b) mit einer ersten Durchlässigkeit auf einem Trägersubstrat (11);
Bilden einer Öffnung (12a, 7a) in dem ersten Film, so dass sie mit einer Anordnungsstelle einer Sensorvorrichtung (3) übereinstimmt;
Füllen der Öffnungen mit einem Isolierelement (25);
Bilden eines ersten Schutzfilms (13) auf dem ersten Film;
Bilden einer lichtemittierenden Schicht (15) auf dem ersten Schutzfilm;
Bilden einer zweiten Schutzschicht (16) auf der lichtemittierenden Schicht;
Entfernen des Isolierelements, um die Öffnungen in dem ersten Film zu bilden, wobei
der erste Film in mindestens einem Teil eines Bereichs (D2), der der Sensorvorrichtung zugewandt ist, gebildet wird, wobei der mindestens eine Teil einen Grenzabschnitt zwischen benachbarten Pixeln innerhalb des Bereichs, der der Sensorvorrichtung zugewandt ist, ausschließt, und
die Öffnung des ersten Films in dem Grenzabschnitt zwischen den benachbarten Pixeln innerhalb des dem Sensor zugewandten Bereichs gebildet wird.

## Revendications

1. Dispositif d'affichage (1) comprenant :
un substrat (4, 5, 6) ;
une première région (D1) d'affichage disposée sur le substrat (4, 5, 6), la première région (D1) d'affichage ayant une pluralité de pixels ; et
une seconde région (D2) d'affichage disposée sur le substrat (4, 5, 6), la seconde région (D2) d'affichage ayant une pluralité de pixels,
dans lequel le substrat (4, 5, 6) a une première transmittance dans la première région (D1) d'affichage, le substrat (4, 5, 6) a une seconde transmittance dans la seconde région (D2) d'affichage supérieure à la première transmittance, la seconde région (D2) d'affichage fait face à un dispositif de détection (3) disposé sur un côté d'une face opposée à une face d'affichage (1a) sur le substrat (4, 5, 6),
un premier film (7b, 12) est disposé sur le côté de la face opposée à la face d'affichage à l'intérieur de la première région (D1) d'affichage et a la première transmittance,
le premier film (7b, 12) est prévu dans au moins une partie de la seconde région (D2) d'affichage, la au moins une partie excluant une partie de limite entre des pixels adjacents à l'intérieur de la seconde région (D2) d'affichage, et
une ouverture (7a, 12a) du premier film (7b, 12) est prévue au niveau de la partie de limite entre les pixels adjacents à l'intérieur de la seconde région (D2) d'affichage.

2. Dispositif d'affichage selon la revendication 1, comprenant en outre : un second film (7c, 20) disposé sur le côté de la face opposée à la face d'affichage à l'intérieur de la seconde région d'affichage, le second film ayant la seconde transmittance.

3. Dispositif d'affichage selon la revendication 1 ou 2, dans lequel un rapport entre une surface du second film et une surface d'une région d'émission de lumière à l'intérieur de la seconde région d'affichage est de 30 % ou plus.

4. Dispositif d'affichage selon l'une quelconque des revendications 1 à 3, dans lequel le second film a pour fonction de bloquer de la lumière infrarouge.

5. Dispositif d'affichage selon l'une quelconque des revendications 1 à 4,
dans lequel le second film est disposé au niveau de l'ouverture formée par retrait d'une partie du premier film, et
une transmittance d'une partie de limite entre le premier film et le second film varie de façon continue ou graduelle à partir du premier film vers le second film.

6. Dispositif d'affichage selon l'une quelconque des revendications 1 à 5,
dans lequel le premier film contient du polyimide, et
le second film contient un matériau présentant une transmittance supérieure à celle du polyimide du premier film.

7. Dispositif d'affichage selon l'une quelconque des revendications 1 à 6,
dans lequel le second film a au moins une partie concave (20a) ou une partie convexe, et le dispositif d'affichage comprend en outre :
une lentille optique (24) comportant le second film, ou une couche de structure de type œil de papillon (moth-eye) comportant le second film.

8. Appareil électronique comprenant :
le dispositif d'affichage selon l'une quelconque des revendications 1 à 7 ; et
le dispositif de détection disposé à l'opposé d'une face d'affichage du dispositif d'affichage.

9. Appareil électronique selon la revendication 8, dans lequel le dispositif de détection comporte un capteur d'imagerie.

10. Appareil électronique selon la revendication 8, dans lequel le dispositif de détection comporte un capteur de détection d'informations biométriques.

11. Appareil électronique selon l'une quelconque des revendications 8 à 10, dans lequel
une pluralité de secondes régions d'affichage sont prévues sur la face d'affichage, et
une pluralité de dispositifs de détection sont disposés en correspondance avec la pluralité de secondes régions d'affichage.

12. Appareil électronique selon la revendication 11, dans lequel les secondes transmittances respectives d'au moins deux de la pluralité de secondes régions d'affichage sont différentes les unes des autres.

13. Procédé de fabrication d'un dispositif d'affichage (1), le procédé comprenant :
la formation d'un premier film (12, 7b) ayant une première transmittance sur un premier substrat de support (11) ;
la formation d'une couche d'émission de lumière (15) sur le premier film (12, 7b) ;
la formation d'un film protecteur (13) sur la couche d'émission de lumière (15) ;
la formation d'un second substrat de support (19) sur le film protecteur (13) ;
le retrait du premier substrat de support (19) ;
la formation d'une ouverture (12a, 7a) au niveau du premier film (12, 7b) en fonction d'un emplacement de disposition d'un dispositif de détection (3), dans lequel
la formation du premier film (12, 7b) dans au moins une partie d'une région (D2) faisant face au dispositif de détection (3), la au moins une partie excluant une partie de limite entre des pixels adjacents à l'intérieur de la région (D2) faisant face au dispositif de détection (3), et
la formation de l'ouverture (12a, 7a) du premier film (12, 7b) au niveau de la partie de limite entre les pixels adjacents à l'intérieur de la région faisant face au dispositif de détection (3).

14. Procédé de fabrication d'un dispositif d'affichage (1), le procédé comprenant :
la formation d'un premier film (12, 7b) ayant une première transmittance sur un substrat de support (11) ;
la formation d'une ouverture (12a, 7a) au niveau du premier film pour qu'elle coïncide avec un emplacement de disposition d'un dispositif de détection (3) ;
le remplissage des ouvertures avec un élément isolant (25) ;
la formation d'un premier film protecteur (13) sur le premier film ;
la formation d'une couche d'émission de lumière (15) sur le premier film protecteur ;
la formation d'un second film protecteur (16) sur la couche d'émission de lumière ;
le retrait de l'élément isolant afin de former les ouvertures au niveau du premier film, dans lequel
la formation du premier film dans au moins une partie d'une région (D2) faisant face au dispositif de détection, la au moins une partie excluant une partie de limite entre des pixels adjacents à l'intérieur de la région faisant face au dispositif de détection, et
la formation de l'ouverture du premier film au niveau de la partie de limite entre les pixels adjacents à l'intérieur de la région faisant face au dispositif de détection.
